# EUROPEAN PATENT SPECIFICATION

(11) **EP 4 582 506 B1**
(45) Date of publication and mention of the grant of the patent: **13.05.2026**
(21) Application number: 24866649.7
(22) Date of filing: 14.06.2024
(51) Int. Cl.: C09J 163/00, C09J 11/04, C09J 175/04, C08G 59/50

(54) **UNDERFILL ADHESIVE FOR ELIMINATING FLOW MARKS AND PREPARATION METHOD THEREFOR, AND FLIP CHIP**
UNTERFÜLLUNGSKLEBSTOFF ZUR BESEITIGUNG VON STRÖMUNGSMARKIERUNGEN UND HERSTELLUNGSVERFAHREN DAFÜR UND FLIPCHIP
ADHÉSIF DE REMPLISSAGE POUR ÉLIMINER DES MARQUES D'ÉCOULEMENT ET SON PROCÉDÉ DE PRÉPARATION, ET PUCE RETOURNÉE

(30) Priority: 27.10.2023 CN 202311408127
(43) Date of publication of application: 09.07.2025
(73) Proprietor: Wuhan Choice Technology Co., Ltd., Wuhan, Hubei 430000 (CN)
(72) Inventor: WU, De, Wuhan, Hubei 430000 (CN); WANG, Shengquan, Wuhan, Hubei 430000 (CN); LIAO, Shuhang, Wuhan, Hubei 430000 (CN); SU, Junxing, Wuhan, Hubei 430000 (CN)
(74) Representative: Chung, Hoi Kan
(86) International application number: PCT/CN2024/099127
(87) International publication number: WO 2025/086670

(56) References cited:
- CN-A- 101 880 514
- CN-A- 102 492 263
- CN-A- 103 725 240
- CN-A- 111 500 239
- CN-A- 113 292 957
- CN-A- 113 403 013
- CN-A- 113 403 013
- CN-A- 113 471 151
- CN-A- 116 120 869
- CN-A- 117 143 550
- JP-A- 2008 274 083
- KR-A- 20130 048 878
- KR-A- 20190 053 057
- US-A1- 2023 260 948
- YU YONG: "Preparation of polyurethane modified epoxy resin adhesive", RUBBER & PLASTICS RESOURCES UTILIZATION, vol. 1, 28 February 2008 (2008-02-28), pages 1 - 4, XP093309454, ISSN: 2096-9619, DOI: 10.3969/j.cn.12-1350(tq).2014.01.001
- LI LI, GUO XUHONG: "An Epoxy Adhesive Modifed by Polyurethane", vol. 2, 15 April 1997 (1997-04-15), XP093309457, ISSN: 1001-0017
- CHEN YU-FEI, LI SHI-XIA, BAI MENG-YAO, XIAO YI-YUE, YUAN GUANG-XUE, ZHANG SHOU-HAO: "Study on the Properties of Epoxy Resins Modified by Nano-Silica", HAERBIN LIGONG DAXUE XUEBAO - HARBIN UNIVERSITY OF SCIENCE ANDTECHNOLOGY. JOURNAL, HA'ERBIN LIGONG DAXUE, HA'ERBIN, CN, vol. 16, no. 4, 25 August 2011 (2011-08-25), CN , pages 21 - 25, XP093309459, ISSN: 1007-2683, DOI: 10.15938/j.jhust.2011.04.005
- ONG S., ISMAIL J., BAKAR M. ABU, RAHMAN I. A., SIPAUT C. S., CHEE C. K.: "Polyurethane‐modified epoxy resin: Solventless preparation and properties", JOURNAL OF APPLIED POLYMER SCIENCE, WILEY SUBSCRIPTION SERVICES, INC., A WILEY COMPANY, NEW YORK, vol. 111, no. 6, 1 January 2009 (2009-01-01), New York, pages 3094 - 3103, XP093309462, ISSN: 0021-8995, DOI: 10.1002/app.29373

## Description

### TECHNICAL FIELD

The present invention belongs to the technical field of underfill adhesives for chips, and particularly relates to an underfill adhesive for eliminating flow marks, a preparation method thereof, and a flip chip.

### BACKGROUND

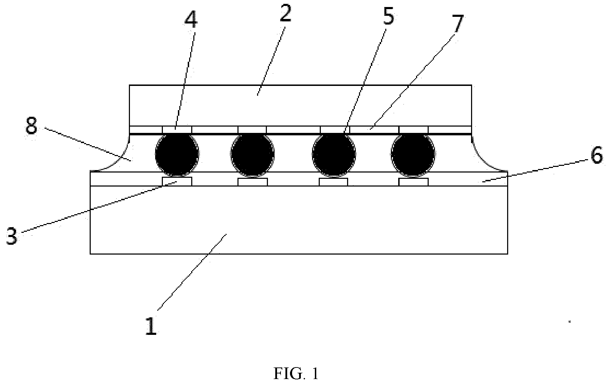

To meet the reliability requirements of electronic devices, flip chips generally adopt an underfill technology. An underfill adhesive is a material suitable for the underfill technology of the flip chips, is generally permeated into a gap between a chip and a substrate by using the principle of a capillary action, and is then gradually solidified by thermal curing and filled in the gap between the chip and the substrate, so as to protect high-density solder bumps between the chip and the substrate as well as the chip. As shown in FIG. 1, a plurality of contact pads 3 are disposed at intervals at an upper end of a substrate 1, bottom-touching metals 4 having a number matched with that of the contact pads are correspondingly disposed at a lower end of a chip 2, a solder bump 5 is disposed between each contact pad and the corresponding bottom-touching metal, a solder mask 6 is disposed between two adjacent contact pads, a passivation layer 7 is disposed between two adjacent bottom-touching metals, and a gap formed among the chip, the substrate, and the solder bumps is filled with an underfill material 8, so that the chip, the substrate, and the solder bumps are protected, a stress loaded on a surface of the chip can be dispersed, and meanwhile, an internal stress caused by mismatch among coefficients of thermal expansion of the chip, the substrate, and the solder bumps is alleviated, the chip can be prevented from damages caused by physical, chemical, and other environmental factors, and the processability, reliability, and service life of the chip and packaging devices can be improved.

However, an existing underfill material formed after curing of an underfill adhesive often cracks and cannot continue to protect the chip; and at the same time, when the underfill adhesive flows in the gap formed among the chip, the substrate, and the solder bumps, flow marks are also produced, which is not conducive to the protection of the chip.

Therefore, how to provide an underfill adhesive to inhibit the production of the flow marks and enhance the protection effect of the chip is a technical problem that needs to be solved urgently by those skilled in the art.

US 2023/260948 A1 discloses an underfill for chip packaging comprising epoxy resin, silica particles as filler, curing agent, accelerator and colorant.

### SUMMARY

The present invention aims to provide an underfill adhesive for eliminating flow marks, a preparation method thereof, and a flip chip, so as to solve at least one of the above-mentioned technical problems.

To achieve the above object, a first aspect of the present invention provides an underfill adhesive for eliminating flow marks, where the underfill adhesive includes the following components in mass percent: 16%-24% of polyurethane modified epoxy resin, 52%-64% of a filler, 19%-23% of a curing agent, 0.2%-0.6% of an accelerator, and 0.1%-0.2% of a colorant.

In the first aspect, the filler includes silicon dioxide, and an average particle diameter of the silicon dioxide is 0.6-5 µm.

In the first aspect, the curing agent includes an amine curing agent.

In the first aspect, the accelerator includes an imidazole accelerator.

In the first aspect, the colorant includes carbon black.

A second aspect of the present invention provides an underfill adhesive, where the underfill adhesive consists of epoxy resin, a filler, a curing agent, an accelerator, and a colorant; and the epoxy resin includes polyurethane modified epoxy resin.

In the second aspect, the filler includes silicon dioxide, and an average particle diameter of the silicon dioxide is 0.6-5 µm; and/or, the curing agent includes an amine curing agent; and/or, the accelerator includes an imidazole accelerator; and/or, the colorant includes carbon black.

A third aspect of the present invention provides a preparation method of an underfill adhesive for eliminating bottom flow marks as described in the first aspect, where the preparation method includes: stirring and mixing components according to a certain proportion to obtain preliminary mixed slurry, where the components include the following components in mass percent: 16%-24% of polyurethane modified epoxy resin, 52%-64% of a filler, 19%-23% of a curing agent, 0.2%-0.6% of an accelerator, and 0.1%-0.2% of a colorant; transferring the preliminary mixed slurry to a three-roller grinder for dispersion treatment to obtain uniformly dispersed slurry; and carrying out vacuum defoaming on the uniformly dispersed slurry to obtain the underfill adhesive.

A fourth aspect of the present invention provides a flip chip, including a substrate, a chip disposed on a surface of the substrate, and a plurality of solder bumps which are disposed at intervals between the substrate and the chip and are electrically connected to the substrate and the chip, where a gap between the substrate and the chip is filled with an underfill material, the underfill material is formed by curing the underfill adhesive for eliminating bottom flow marks as described in the first aspect, the chip has a size of greater than 10 mm×25 mm, and the gap between the chip and the substrate is less than 30 µm.

A fifth aspect of the present invention provides a preparation method of a flip chip, where the preparation method includes: obtaining a flip chip body, where the flip chip body includes a substrate, a chip disposed on a surface of the substrate, and a plurality of solder bumps which are disposed at intervals between the substrate and the chip and are electrically connected to the substrate and the chip, and a gap is formed between the substrate and the chip; disposing the underfill adhesive for eliminating bottom flow marks as described in the first aspect on an edge of the flip chip such that the underfill adhesive flows from one end of the gap to the other end of the gap by a capillary action, so as to fill the gap; and heating, allowing the underfill adhesive to be cured in the gap to obtain the flip chip.

### BENEFICIAL EFFECTS:

The underfill adhesive for eliminating flow marks provided by the present invention includes the following components in mass percent: 16%-24% of polyurethane modified epoxy resin, 52%-64% of a filler, 19%-23% of a curing agent, 0.2%-0.6% of an accelerator, and 0.1%-0.2% of a colorant. The polyurethane modified epoxy resin has an interpenetrating network structure and contains a large amount of carbonyl, alcohol, and amino groups, so that the polarity of the epoxy resin is enhanced, a stronger acting force on the filler is further provided, the surface performance of the filler is effectively improved, and the compatibility between the polyurethane modified epoxy resin and the filler is improved, allowing the underfill adhesive to achieve a certain fluidity. In addition, when adhesive liquid of the underfill adhesive fills the gap by flow-casting, it is less likely to produce agglomerates, and thus the production of flow marks can be inhibited. Meanwhile, the underfill adhesive provided by the present application is prepared from the polyurethane modified epoxy resin, the filler, the curing agent, the accelerator, and the colorant according to a specific proportion. According to the underfill adhesive, good compatibility between polyurethane epoxy resin and the filler is utilized, the curing agent is added to make a reaction system change from a flowing state to a solid state, and the accelerator is added to accelerate a reaction rate, thereby improving a curing rate of the underfill adhesive and further improving fabrication efficiency of the flip chip.

### BRIEF DESCRIPTION OF THE DRAWINGS

To illustrate the technical solutions in the embodiments of the present invention or in the prior art more clearly, the following briefly introduces the accompanying drawings to be used for describing the embodiments. Obviously, the accompanying drawings in the following description only show some embodiments of the present invention, and those skilled in the art may still derive other accompanying drawings from these accompanying drawings without creative efforts.
FIG. 1 is a schematic structural diagram of a flip chip in the prior art; and

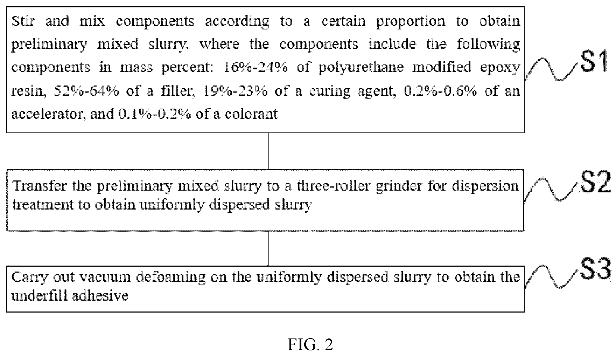

FIG. 2 is a flowchart of a preparation method of an underfill adhesive for eliminating bottom flow marks according to the present application.

Reference numerals:
1. substrate; 2. chip; 3. contact pad; 4. bottom-touching metal; 5. solder bump; 6. solder mask; 7. passivation layer; 8. underfill material.

### DETAILED DESCRIPTION OF THE EMBODIMENTS

The present invention will be described in detail in combination with specific implementations and embodiments, from which the advantages and various effects of the present invention will be presented more clearly. Those skilled in the art should understand that these specific implementations and embodiments are used to illustrate the present invention, but not to limit the present invention.

Throughout the description, unless otherwise specified, the terms used herein should be understood as having meanings commonly used in the art. Therefore, unless otherwise defined, all technical and scientific terms used herein have the same meanings as those commonly understood by those skilled in the art to which the present invention belongs. If there is a conflict, the description takes precedence.

Unless otherwise specified, various raw materials, reagents, instruments, devices, etc. used in the present invention can be purchased from the market or can be prepared by existing methods.

The present application provides an underfill adhesive for eliminating flow marks, where the underfill adhesive includes the following components in mass percent: 16%-24% of polyurethane modified epoxy resin, 52%-64% of a filler, 19%-23% of a curing agent, 0.2%-0.6% of an accelerator, and 0.1%-0.2% of a colorant.

The underfill adhesive for eliminating flow marks provided by the present invention includes the following components in mass percent: 16%-24% of polyurethane modified epoxy resin, 52%-64% of a filler, 19%-23% of a curing agent, 0.2%-0.6% of an accelerator, and 0.1%-0.2% of a colorant. The polyurethane modified epoxy resin has an interpenetrating network structure and contains a large amount of carbonyl, alcohol, and amino groups, so that the polarity of the epoxy resin is enhanced, a stronger acting force on the filler is further provided, the surface performance of the filler is effectively improved, and the compatibility between the polyurethane modified epoxy resin and the filler is improved, allowing the underfill adhesive to achieve a certain fluidity. In addition, when adhesive liquid of the underfill adhesive fills the gap by flow-casting, it is less likely to produce agglomerates, and thus the production of flow marks can be inhibited. Meanwhile, the underfill adhesive provided by the present application is prepared from the polyurethane modified epoxy resin, the filler, the curing agent, the accelerator, and the colorant according to a specific proportion. According to the underfill adhesive, good compatibility between polyurethane epoxy resin and the filler is utilized, the curing agent is added to make a reaction system change from a flowing state to a solid state, and the accelerator is added to accelerate a reaction rate, thereby improving a curing rate of the underfill adhesive and further improving fabrication efficiency of the flip chip.

In some possible embodiments, the filler includes silicon dioxide, and an average particle diameter of the silicon dioxide is 0.6-5 µm.

The filler includes the silicon dioxide to reduce a coefficient of thermal expansion of the underfill adhesive; and in addition, the average particle diameter of the silicon dioxide is 0.6-5 µm, so that by controlling the average particle diameter of the silicon dioxide, a rate at which the underfill adhesive flow-casts in the gap can be controlled, and the production of the agglomerates can be inhibited.

In some possible embodiments, the curing agent includes an amine curing agent. Preferably, the amine curing agent may be diethyltoluenediamine, ethylenediamine, etc., which can react with epoxy resin at a certain temperature and under the action of an accelerator, thereby enabling the system to change from a flowing state to a solid state.

In some possible embodiments, the accelerator includes an imidazole accelerator. Preferably, the imidazole accelerator may be 1-cyanoethyl-2-ethyl-4-methylimidazole, N-methylimidazole, etc., which does not work at room temperature but can promote the reaction at a certain temperature. In other words, the imidazole accelerator can extend the storage life of the underfill adhesive.

In some possible embodiments, the colorant includes carbon black. The colorant is used for dyeing the underfill adhesive for easy identification.

Based on a general inventive concept, the present application further provides an underfill adhesive, where the underfill adhesive consists of epoxy resin, a filler, a curing agent, an accelerator, and a colorant; the epoxy resin includes polyurethane modified epoxy resin; the filler includes silicon dioxide; and an average particle diameter of the silicon dioxide is 0.6-5 µm.

As another alternative embodiment, the curing agent can be selected from amine curing agents; as another alternative embodiment, the accelerator can be selected from imidazole accelerators; and as another alternative embodiment, the colorant can be selected from carbon black.

Based on a general inventive concept, the present application also provides a preparation method of the underfill adhesive for eliminating bottom flow marks as described above, where the preparation method includes:
S1: stirring and mixing components according to a certain proportion to obtain preliminary mixed slurry, where the components include the following components in mass percent: 16%-24% of polyurethane modified epoxy resin, 52%-64% of a filler, 19%-23% of a curing agent, 0.2%-0.6% of an accelerator, and 0.1%-0.2% of a colorant, where a stirring and mixing time is 85-255 s, an autorotation rate is 950 r/min, and a revolution rate is 1050 r/min;
S2: transferring the preliminary mixed slurry to a three-roller grinder for dispersion treatment to obtain uniformly dispersed slurry, where a feeding gap in the three-roller grinder is 15-50 µm, and a discharging gap is 5-25 µm; and
S3: carrying out vacuum defoaming on the uniformly dispersed slurry to obtain the underfill adhesive, where the vacuum defoaming is carried out in a centrifugal mixer, a vacuum defoaming time is 30-60 s, an autorotation rate is 950 r/min, and a revolution rate is 1050 r/min.

Based on a general inventive concept, the present application also provides a flip chip, including a substrate, a chip disposed on a surface of the substrate, and a plurality of solder bumps which are disposed at intervals between the substrate and the chip and are electrically connected to the substrate and the chip, where a gap between the substrate and the chip is filled with an underfill material, the underfill material is formed by curing the underfill adhesive for eliminating bottom flow marks as described in the first aspect, the chip has a size of greater than 10 mm×25 mm, and the gap between the chip and the substrate is less than 30 µm.

Based on a general inventive concept, the present application also provides a preparation method of a flip chip, where the preparation method includes: obtaining a flip chip body, where the flip chip body includes a substrate, a chip disposed on a surface of the substrate, and a plurality of solder bumps which are disposed at intervals between the substrate and the chip and are electrically connected to the substrate and the chip, and a gap is formed between the substrate and the chip; disposing the underfill adhesive for eliminating bottom flow marks as described in the first aspect on an edge of the flip chip such that the underfill adhesive flows from one end of the gap to the other end of the gap by a capillary action, so as to fill the gap; and heating, allowing the underfill adhesive to be cured in the gap to obtain the flip chip.

The present application will be further illustrated below in conjunction with specific examples. It shall be understood that, these examples are used for illustrative purposes only, not limitative to the scope of the present application. In the examples below, measurements in the experimental methods with specific conditions unspecified are typically performed in accordance with national standards. In case of absence of the respective national standards, measurements are performed in accordance with general international standards and general conditions or in accordance with conditions suggested by manufacturers.

The components of the underfill adhesives in Examples 1 to 3 and Comparative Examples 1 to 6 are shown in the table below in mass percent:

| Component | Exa mple 1 | Exa mple 2 | Exa mple 3 | Compa rative Examp le 1 | Compa rative Examp le 2 | Compa rative Examp le 3 | Compa rative Examp le 4 | Compa rative Examp le 5 | Compa rative Examp le 6 |
|---|---|---|---|---|---|---|---|---|---|
| EPU300A | 23 | 16 | 24 | - | - | 15 | 25 | 25 | 15 |
| Bisphenol A-type epoxy resin | - | - | - | 23 | - | - | - | - | - |
| Bisphenol F-type epoxy resin | - | - | - | - | 23 | - | - | - | - |
| Silicon dioxide | 55.5 | 62.5 | 54.5 | 55.5 | 55.5 | 63.5 | 55.5 | 50.2 | 66.2 |
| Diethyltolue nediamine | 21 | 21 | 21 | 21 | 21 | 21 | 19 | 24 | 18 |
| 1-cyanoethyl-2-ethyl-4-methylimida zole | 0.4 | 0.4 | 0.4 | 0.4 | 0.4 | 0.4 | 0.4 | 0.7 | 0.7 |
| Carbon black | 0.1 | 0.1 | 0.1 | 0.1 | 0.1 | 0.1 | 0.1 | 0.1 | 0.1 |

The underfill adhesives provided in Examples 1 to 3 and Comparative Examples 1 to 6 were tested for a fluidity, a storage modulus, a glass transition temperature, a coefficient of thermal expansion, and an adhesion, and a specific test process was as follows:
1. A fluidity test method: four corners of a square glass sheet with a size of 20 mm×20 mm and a thickness of 0.5 mm were stuck on a glass slide by using a double-sided adhesive with a thickness of 30 um, the glass slide was placed on an electric heating plate of 90°C and preheated for three minutes, a to-be-tested underfill adhesive was transversely smeared along one edge of the square glass sheet by using a thin steel needle, and timing was started at the same time, under the action of a capillary force, the underfill adhesive could flow at the bottom of the glass sheet, the time when the underfill adhesive flowed to half the length of the edge and the time when the underfill adhesive flowed to the full length of the edge were recorded, and whether flow marks were produced was observed with naked eyes.
2. Storage modulus: reference standard: ASTM E2254-2018, a sample cured completely at 150°C for 2 h was taken, a test sample with a size of 55 mm×10 mm×2 mm was prepared, and the sample was measured by DMA, where a measurement mode was dual cantilever mode, a vibration frequency was 1 Hz; an amplitude was 10 µm; a heating rate was 3°C/min; and the storage modulus was measured at 25°C-260°C.
3. Glass transition temperature Tg: a sample cured completely at 150°C for 2 h was taken, and a test sample with a size of 5 mm×5 mm×2 mm was prepared. The glass transition temperature of the sample was tested by TMA (compression mode). Parameter setting of the TMA: preloading force: 0.05 N; first scanning: room temperature to 250°C (heating rate of 10°C/min); second scanning: room temperature to 250°C (heating rate of 10°C/min), and curve data of a second heating segment was taken.
4. Coefficient of thermal expansion: reference standard: ASTME831-2019, a sample cured completely at 150°C for 2 h was taken, and a test sample with a size of 5 mm×5 mm×2 mm was prepared. The coefficient of thermal expansion of the sample was tested by TMA (compression mode). Parameter setting of the TMA: preloading force: 0.05 N; first scanning: room temperature to 250°C (heating rate of 10°C/min); second scanning: room temperature to 250°C (heating rate of 10°C/min), and curve data of a second heating segment was taken; and the coefficients of thermal expansion CTE1/2 were measured at 40°C-100°C and 150°C-200°C, respectively.
5. An adhesion test method: a sample was poured in a pudding mold with a diameter of 3 mm and a height of 2 mm, one end of a poured sample was in contact with a copper sheet or a silicon sheet, the copper sheet or the silicon sheet was fixed with the pudding mold, the pudding mold was removed after curing at 150°C for 2 h, the sample was taken out and tested by using a thrust machine at a thrust speed of 50 µm/s and a contact height of 20 µm, and adhesions to the silicon sheet and the copper sheet were recorded.
6. A high-temperature and high-pressure cooking (PCT) test: a sample was cured at 150°C for 2 h, and after curing was completed, the sample was placed at 120°C for 20 h to perform the PCT test, the sample was then measured according to the above test method, and a storage modulus, a glass transition temperature Tg, coefficients of thermal expansion CTE1/2, and adhesions to the silicon sheet and the copper sheet were recorded.

Fluidity test results were shown in the table below:

| Test item s | Exa mpl e 1 | Exam ple 2 | Exam ple 3 | Compar ative Example 1 | Compar ative Example 2 | Compar ative Example 3 | Compar ative Example 4 | Compar ative Example 5 | Compar ative Example 6 |
|---|---|---|---|---|---|---|---|---|---|
| Is there any flow mark in the 30 µm gap | Non e | None | None | Yes | Yes | Yes | Yes | Yes | Yes |
| Is there any flow mark in the 40 µm gap | Non e | None | None | Yes | Yes | Yes | Yes | None | Yes |
| Is there any flow mark in the 60 µm gap | Non e | None | None | None | None | None | None | None | Yes |

As shown in the above table, the epoxy resins used in Comparative Examples 1 and 2 were unmodified bisphenol A-type epoxy resin and unmodified bisphenol F-type epoxy resin, respectively. When the gap was 60 µm, no flow marks appeared, and when the gap was reduced to 40 µm and 30 µm, flow marks appeared. However, for the polyurethane modified epoxy resin used in Example 1, no flow marks appeared when the gap was 40 µm or 30 µm, respectively, indicating that the polyurethane modified epoxy resin has better compatibility with silicon dioxide. Although the polyurethane modified epoxy resin was also used in Comparative Examples 3 and 4, flow marks also appeared when the gaps were reduced to 40 µm and 30 µm, indicating that the polyurethane modified epoxy resin can only control the production of flow marks in specific proportions. Comparative Example 5 had relatively small viscosity and good fluidity due to low solid content, resulting in an increase in pressure difference during flow, however, although no flow marks appeared when flowing in the gaps of 40 µm and 60 µm, flow marks appeared when the gap was further reduced to 30 µm. Comparative Example 6 had relatively large viscosity and poor fluidity due to high solid content, resulting in small pressure difference during flow, and thus flow marks appeared when the gap was 30 µm, 40 µm, and 60 µm, respectively. Therefore, only when the components of the underfill adhesive were in a specific proportion, the production of flow marks can be inhibited. From this, it can be inferred that a possible mechanism of action for the underfill adhesive is as follows:

The power that an adhesive body flows in a gap of a chip mainly comes from the pressure difference. In the gap at the bottom of the chip, due to the pressure difference, the adhesive body will flow from one end of the gap to the other end thereof. If the gap is too small, then friction increases, and the friction causes loss to kinetic energy of the adhesive body during flowing, which makes a flowing speed lower and lower. If the gap is too large, then leakage increases, and the adhesive body will overflow from the other end of the gap. In practical applications, the gap between chips is generally 30-60 um, with a square shape of 10-25 mm in length and width. The selected filler is silicon dioxide, with an average particle diameter of 0.6-5 um. During a flowing process, if the adhesive liquid is closer to the other end of the gap, then the kinetic energy of flowing is smaller. A small part of the silicon dioxide will agglomerate to stop flowing, agglomerates prevent the adhesive body from continuing to flow, the formation of a plurality of agglomerates results in production of dendritic flow marks, and adhesive materials which produce flow marks are considered as unqualified products.

The agglomerates are produced due to poor compatibility and small bonding force between the silicon dioxide and the resin. If resins having good compatibility with the silicon dioxide are used, then the flow marks can be effectively eliminated. According to the present application, the polyurethane modified epoxy resin is selected for use. Since the polyurethane modified epoxy resin contains a large amount of carbonyl, alcohol, and amino groups, the polarity of the resin is enhanced, and a stronger acting force on the silicon dioxide is further provided. Therefore, the acting force between the resin and the silicon dioxide is greater, the compatibility therebetween is better, agglomerates are not easy to be produced, and thus no flow marks are produced.

The DMA and TMA test results of the underfill adhesive provided by the present application after curing at 150°C for 2 h were shown in the table below:

| Test items | Storage modulus (GPa) | CTE1/2 | Tg (°C) | Adhesion to silicon sheet (MPa) | Adhesion to copper sheet (MPa) |
|---|---|---|---|---|---|
| Example 1 | 6.8/0.13 | 27.8/91.2 | 125.8 | 13.7 | 6.8 |
| Example 2 | 7.8/0.25 | 22.4/82.6 | 132.2 | 12.5 | 6.4 |
| Example 3 | 6.5/0.10 | 25.5/88.7 | 124.8 | 12.8 | 6.7 |
| Comparative Example 1 | 6.5/0.10 | 30.2/95.6 | 122.5 | 6.8 | 3.6 |
| Comparative Example 2 | 6.3/0.08 | 31.5/96.3 | 120.1 | 6.6 | 3.5 |
| Comparative Example 3 | 7.5/0.15 | 26.8/85.7 | 135.5 | 8.5 | 4.4 |
| Comparative Example 4 | 6.6/0.12 | 30.8/94.2 | 125.3 | 7.5 | 3.8 |
| Comparative Example 5 | 5.2/0.05 | 37.5/120.4 | 115.1 | 5.8 | 3.1 |
| Comparative Example 6 | 7.8/0.20 | 24.8/83.2 | 136.8 | 6.4 | 3.7 |

The DMA and TMA test results of the underfill adhesive provided by the present application, after curing at 150°C for 2 h, followed by a high-temperature and high-pressure cooking test (PCT) (test conditions: a test temperature of 120°C and a test time of 20 h), were shown in the table below:

| Test item | Storage modulus (GPa) | CTE1/2 | Tg (°C) | Adhesion to silicon sheet (MPa) | Adhesion to copper sheet (MPa) |
|---|---|---|---|---|---|
| Example 1 | 5.7/0.10 | 29.5/93.6 | 117.9 | 12.0 | 6.1 |
| Example 2 | 6.8/0.20 | 24.5/85.1 | 125.6 | 11.8 | 5.8 |
| Example 3 | 5.4/0.07 | 27.4/90.3 | 115.7 | 11.7 | 6.0 |
| Comparative Example 1 | 5.3/0.08 | 32.5/96.8 | 118.2 | 3.2 | 1.2 |
| Comparative Example 2 | 5.1/0.05 | 33.1/98.5 | 115.5 | 3.5 | 1.4 |
| Comparative Example 3 | 6.2/0.10 | 28.8/88.4 | 125.6 | 5.2 | 2.2 |
| Comparative Example 4 | 5.4/0.10 | 32.4/96.7 | 117.5 | 6.0 | 2.8 |
| Comparative Example 5 | 4.7/0.03 | 39.1/125.4 | 109.2 | 4.5 | 2.0 |
| Comparative Example 6 | 6.8/0.15 | 26.7/85.5 | 128.9 | 5.0 | 2.2 |

Based on the above table: through the comparison of Comparative Example 1, Comparative Example 2, and Example 1, it can be seen that in the case of the same filler, a storage modulus of the polyurethane modified epoxy resin was greater than that of the bisphenol A-type epoxy resin and the bisphenol F-type epoxy resin, and a coefficient of expansion of the polyurethane modified epoxy resin was less than that of the bisphenol A-type epoxy resin and the bisphenol F-type epoxy resin; and through the comparison of the example and the comparative examples, it can be seen that by adding an appropriate amount of polyurethane modified epoxy resin in the underfill adhesive of the examples, the adhesions to the silicon sheet and the copper sheet can be improved, but at the same time, the adhesions to the silicon sheet and the copper sheet were also related to the solid content of the system.

After performing high-temperature and high-pressure cooking at 120°C for 20 h, within a range of proportions of the components provided by the present application, the underfill adhesive still has a high storage modulus after curing and the PCT test, and the adhesions to the silicon sheet and the copper sheet slightly decrease; however, when not within the range of proportions provided by the present application or when using the bisphenol A-type epoxy resin and the bisphenol F-type epoxy resin, the adhesions significantly decrease.

Moreover, the terminology "comprising", "including" or any other alterations are intended to cover non-exclusive inclusion, so as to make a process, method, article or apparatus including a series of elements further includes elements that are not listed explicitly other than said series of elements, or includes elements inherent to such process, method, article or apparatus.

Although the preferred embodiments of the present invention have been described, those skilled in the art benefiting from the underlying inventive concept can make additional modifications and variations to these embodiments. Therefore, the appended claims are intended to be construed as encompassing the embodiments and all the modifications and variations falling in the scope of the present invention.

Apparently, various modifications and variations to the present invention can be made by those skilled in this art without departing from the spirit and scope of the present invention. Thereby, the present invention intends to encompass all such modifications and variations within the scope of the claims of the present invention and its equivalents.

## Claims

1. An underfill adhesive for eliminating flow marks, **characterized in that** the underfill adhesive consists of the following components in mass percent: 16%-24% of polyurethane modified epoxy resin, 52%-64% of a filler, 19%-23% of a curing agent, 0.2%-0.6% of an accelerator, and 0.1%-0.2% of a colorant;
the filler is silicon dioxide, and an average particle diameter of the silicon dioxide is 0.6-5 µm; and
the polyurethane modified epoxy resin is EPU300A.

2. The underfill adhesive for eliminating flow marks according to claim 1, **characterized in that** the curing agent comprises an amine curing agent.

3. The underfill adhesive for eliminating flow marks according to claim 2, **characterized in that** the accelerator comprises an imidazole accelerator.

4. The underfill adhesive for eliminating flow marks according to claim 3, **characterized in that** the colorant comprises carbon black.

5. A preparation method of the underfill adhesive for eliminating bottom flow marks according to any one of claims 1 to 4, **characterized in that** the preparation method comprises:
stirring and mixing components according to a certain proportion to obtain preliminary mixed slurry, wherein the components comprise the following components in mass percent: 16%-24% of polyurethane modified epoxy resin, 52%-64% of a filler, 19%-23% of a curing agent, 0.2%-0.6% of an accelerator, and 0.1%-0.2% of a colorant;
transferring the preliminary mixed slurry to a three-roller grinder for dispersion treatment to obtain uniformly dispersed slurry; and
carrying out vacuum defoaming on the uniformly dispersed slurry to obtain the underfill adhesive.

6. A flip chip, comprising a substrate, a chip disposed on a surface of the substrate, and a plurality of solder bumps which are disposed at intervals between the substrate and the chip and are electrically connected to the substrate and the chip, wherein a gap between the substrate and the chip is filled with an underfill material, **characterized in that**
the underfill material is formed by curing the underfill adhesive for eliminating bottom flow marks according to any one of claims 1 to 4, the chip has a size of greater than 10 mm×25 mm, and the gap between the chip and the substrate is less than 30 µm.

7. A preparation method of a flip chip, **characterized by** comprising:
obtaining a flip chip body, wherein the flip chip body comprises a substrate, a chip disposed on a surface of the substrate, and a plurality of solder bumps which are disposed at intervals between the substrate and the chip and are electrically connected to the substrate and the chip, and a gap is formed between the substrate and the chip;
disposing the underfill adhesive for eliminating bottom flow marks according to any one of claims 1 to 4 on an edge of the flip chip such that the underfill adhesive flows from one end of the gap to the other end of the gap by a capillary action, so as to fill the gap; and
heating, allowing the underfill adhesive to be cured in the gap to obtain the flip chip.

## Patentansprüche

1. Unterfüllklebstoff zur Beseitigung von Fließmarken, **dadurch gekennzeichnet, dass** der Unterfüllklebstoff aus den folgenden Komponenten in Massenprozent besteht: 16%-24% polyurethanmodifiziertes Epoxidharz, 52%-64% eines Füllstoffs, 19%-23% eines Härtungsmittels, 0,2%-0,6% eines Beschleunigers und 0,1%-0,2% eines Farbstoffs,
wobei der Füllstoff Siliziumdioxid ist und ein durchschnittlicher Partikeldurchmesser des Siliziumdioxids 0,6-5 µm beträgt und
das polyurethanmodifizierte Epoxidharz EPU300A ist.

2. Unterfüllklebstoff zur Beseitigung von Fließmarken nach Anspruch 1, **dadurch gekennzeichnet, dass** das Härtungsmittel einen Aminhärter umfasst.

3. Unterfüllklebstoff zur Beseitigung von Fließmarken nach Anspruch 2, **dadurch gekennzeichnet, dass** der Beschleuniger einen Imidazolbeschleuniger umfasst.

4. Unterfüllklebstoff zur Beseitigung von Fließmarken nach Anspruch 3, **dadurch gekennzeichnet, dass** der Farbstoff Ruß umfasst.

5. Herstellungsverfahren für den Unterfüllklebstoff zur Beseitigung von unterseitigen Fließmarken nach einem der Ansprüche 1 bis 4, **dadurch gekennzeichnet, dass** das Herstellungsverfahren Folgendes umfasst:
Rühren und Mischen von Komponenten gemäß einem bestimmten Verhältnis, um eine vorläufig gemischte Aufschlämmung zu erhalten, wobei die Komponenten die folgenden Komponenten in Massenprozent umfassen: 16%-24% polyurethanmodifiziertes Epoxidharz, 52%-64% eines Füllstoffs, 19%-23% eines Härtungsmittels, 0,2%-0,6% eines Beschleunigers und 0,1%-0,2% eines Farbstoffs;
Überführen der vorläufig gemischten Aufschlämmung in ein Dreiwalzwerk zur Dispergierbehandlung, um eine gleichmäßig dispergierte Aufschlämmung zu erhalten, und
Durchführen einer Vakuumentschäumung auf der gleichmäßig dispergierten Aufschlämmung, um den Unterfüllklebstoff zu erhalten.

6. Flip-Chip, umfassend ein Substrat, einen auf einer Oberfläche des Substrats angeordneten Chip und eine Vielzahl von Lotbumps, die in Abständen zwischen dem Substrat und dem Chip angeordnet sind und elektrisch mit dem Substrat und dem Chip verbunden sind, wobei ein Spalt zwischen dem Substrat und dem Chip mit einem Unterfüllmaterial gefüllt ist, **dadurch gekennzeichnet, dass**
das Unterfüllmaterial gebildet wird, indem der Unterfüllklebstoff zur Beseitigung unterseitiger Fließmarken nach einem der Ansprüche 1 bis 4 ausgehärtet wird, wobei der Chip eine Größe von mehr als 10 mm x 25 mm aufweist und der Spalt zwischen dem Chip und dem Substrat kleiner als 30 µm ist.

7. Herstellungsverfahren für einen Flip-Chip, **dadurch gekennzeichnet, dass** es Folgendes umfasst:
Erhalten eines Flip-Chip-Körpers, wobei der Flip-Chip-Körper ein Substrat, einen auf einer Oberfläche des Substrats angeordneten Chip und eine Vielzahl von Lotbumps, die in Abständen zwischen dem Substrat und dem Chip angeordnet sind und elektrisch mit dem Substrat und dem Chip verbunden sind, umfasst und ein Spalt zwischen dem Substrat und dem Chip gebildet ist;
Anordnen des Unterfüllklebstoffs zur Beseitigung von unterseitigen Fließmarken nach einem der Ansprüche 1 bis 4 auf einer Kante des Flip-Chips, sodass der Unterfüllklebstoff durch eine Kapillarwirkung von einem Ende des Spalts zum anderen Ende des Spalts fließt, um den Spalt zu füllen, und
Erhitzen, wodurch der Unterfüllklebstoff in dem Spalt ausgehärtet werden kann, um den Flip-Chip zu erhalten.

## Revendications

1. Adhésif de remplissage pour éliminer des marques d'écoulement, **caractérisé en ce que** l'adhésif de remplissage est constitué des composants suivants en pourcentage en masse : 16%-24% de résine époxy modifiée par polyuréthane, 52%-64% d'une charge, 19%-23% d'un agent de durcissement, 0,2%-0,6% d'un accélérateur, et 0,1%-0,2% d'un colorant ;
la charge est du dioxyde de silicium, et un diamètre moyen de particule du dioxyde de silicium est de 0,6-5 µm ; et
la résine époxy modifiée par polyuréthane est l'EPU300A.

2. Adhésif de remplissage pour éliminer des marques d'écoulement selon la revendication 1, **caractérisé en ce que** l'agent de durcissement comprend un agent de durcissement d'amine.

3. Adhésif de remplissage pour éliminer des marques d'écoulement selon la revendication 2, **caractérisé en ce que** l'accélérateur comprend un accélérateur à base d'imidazole.

4. Adhésif de remplissage pour éliminer des marques d'écoulement selon la revendication 3, **caractérisé en ce que** le colorant comprend du noir de carbone.

5. Procédé de préparation de l'adhésif de remplissage pour éliminer des marques d'écoulement inférieures selon l'une quelconque des revendications 1 à 4, **caractérisé en ce que** le procédé de préparation comprend :
l'agitation et le mélange des composants selon une certaine proportion pour obtenir une suspension prémélangée, dans lequel les composants comprennent les composants suivants en pourcentage en masse : 16%-24% de résine époxy modifiée par polyuréthane, 52%-64% d'une charge, 19%-23% d'un agent de durcissement, 0,2%-0,6% d'un accélérateur, et 0,1%-0,2% d'un colorant ;
le transfert de la suspension prémélangée vers un broyeur à trois rouleaux pour un traitement de dispersion pour obtenir une suspension uniformément dispersée ; et
la réalisation d'un démoussage sous vide sur la suspension uniformément dispersée pour obtenir l'adhésif de remplissage.

6. Puce retournée, comprenant un substrat, une puce disposée sur une surface du substrat, et une pluralité de bosses de soudure qui sont disposées à des intervalles entre le substrat et la puce et sont connectées électriquement au substrat et à la puce, dans laquelle un espace entre le substrat et la puce est rempli d'un matériau de remplissage, **caractérisée en ce que**
le matériau de remplissage est formé par durcissement de l'adhésif de remplissage pour éliminer les marques d'écoulement inférieures selon l'une quelconque des revendications 1 à 4, la puce présente une taille supérieure à 10 mm x 25 mm, et l'espace entre la puce et le substrat est inférieur à 30 µm.

7. Procédé de préparation d'une puce retournée, **caractérisé en ce qu'**il comprend :
l'obtention d'un corps de puce retournée, dans lequel le corps de puce retournée comprend un substrat, une puce disposée sur une surface du substrat, et une pluralité de bosses de soudure qui sont disposées à des intervalles entre le substrat et la puce et sont connectées électriquement au substrat et à la puce, et un espace est formé entre le substrat et la puce ;
la disposition de l'adhésif de remplissage pour éliminer les marques d'écoulement inférieures selon l'une quelconque des revendications 1 à 4 sur un bord de la puce retournée de telle sorte que l'adhésif de remplissage s'écoule d'une extrémité de l'espace à l'autre extrémité de l'espace par une action capillaire, de manière à remplir l'espace ; et
le chauffage, permettant à l'adhésif de remplissage d'être durci dans l'espace pour obtenir la puce retournée.
